# EUROPEAN PATENT SPECIFICATION

(11) **EP 2 824 718 B1**
(45) Date of publication and mention of the grant of the patent: **07.09.2016**
(21) Application number: 14175517.3
(22) Date of filing: 03.07.2014
(51) Int. Cl.: H01L 31/048

(54) **Photovoltaic module and fabricating method thereof**
Fotovoltaisches Modul und Herstellungsverfahren
Module photovoltaïque et son procédé de fabrication

(30) Priority: 11.07.2013 KR 20130081697
(43) Date of publication of application: 14.01.2015
(73) Proprietor: LSIS Co., Ltd., Anyang-si, Gyeonggi-do 431-848 (KR)
(72) Inventor: Won, Chang Sub, 431-848 Anyang-si, Gyeonggi-do (KR); Kim, Dong Chan, 431-848 Anyang-si, Gyeonggi-do (KR); Kang, Bo Ram, 431-848 Anyang-si, Gyeonggi-do (KR); Lee, Jin, 431-848 Anyang-si, Gyeonggi-do (KR); Waithiru, Lawrence, 431-848 Anyang-si, Gyeonggi-do (KR)
(74) Representative: Lang, Johannes

(56) References cited:
- EP-A1- 2 117 050
- WO-A1-2010/101582
- KR-A- 20120 078 026
- KR-A- 20120 121 363
- US-A1- 2011 139 224

## Description

### BACKGROUND OF THE DISCLOSURE

### 1. Field of the Disclosure

This specification relates to a photovoltaic module, and more particularly, a photovoltaic module using a polyolefin (LDPE)-based encapsulant, and a fabricating method thereof.

### 2. Background of the Disclosure

A photovoltaic cell (or solar cell) is an apparatus for absorbing solar rays and acquiring energy. The photovoltaic cell is fabricated in a form of a module, in which a plurality of solar cells are arranged within a package to be appropriate for requirements, such as cell capacity and the like. The photovoltaic cell module (or photovoltaic module) is in the spotlight as one alternative for solving environmental problems, such as exhaustion of oil resources, global warming and the like, in view of the use of clean energy sources, unlimitedly usability, and less maintenance costs.

The photovoltaic module has a multi-layered structure for protecting solar cells from external environments. In order to strongly bond the solar cells and materials, which are laminated on front and rear surfaces of each solar cells, an ethylene vinyl acetate (EVA)-based film is generally used. The EVA film also protects the solar cells from an external impact and enhance light transmission, as well as allowing for strong bonding between the solar cells and other materials.

However, the EVA film is disadvantageously vulnerable to moisture, which permeates through a back sheet located at the rear surface of the solar cell and a side surface of the solar cell. That is, if the EVA is used as an encapsulant, moisture may easily permeate through the back sheet or the side surface of the solar cell, which may cause a bonding force of the EVA film to be lowered, thereby causing delamination.

In addition, the EVA film may react with the permeated moisture in view of a characteristic of an EVA group, so as to generate acetic acid, which may cause yellowing. The yellowing caused due to the acetic acid may lower light transmittance of the photovoltaic module and corrode an electrode portion of the solar cell. As a result, when the photovoltaic module is used in a humid environment in the related art, such use gives rise to a shortening of a full lifespan and lowering of efficiency of the photovoltaic module.

The acetic acid generated from the EVA may induce wastewater containing 0.1 to 1.5% of acetic acid. The wastewater containing the acetic acid may acidify a nearby land (soil), and threaten health of a person when the person touches or comes in contact with the wastewater, such as irritating the person's eyes and nose. Also, a lot of costs are required to treat the wastewater containing the acetic acid, or an environmental pollution, such as generation of a large quantity of carbon dioxide, may be caused during the treatment.

Taking this into account, this applicant has introduced a photovoltaic module, which exhibits high moisture-resistant property, does not cause yellowing and provides high efficiency under a humid condition, by employing a low-density polyethylene (LDPE) protection film, in the invention titled "moisture-resistant photovoltaic module and fabricating method thereof," which has been filed on July 8, 2011 and issued on January 3, 2013.

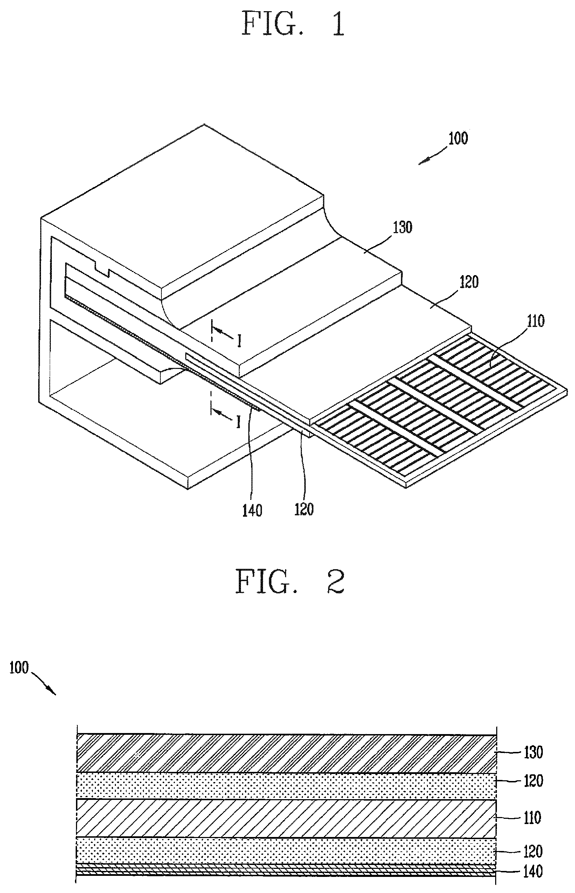

FIG. 1 is a side view of a moisture-resistant photovoltaic module employing an LDPE protection film according to the related art, and FIG. 2 is a sectional view taken along the line 'I-I' of FIG. 1.

As illustrated in FIGS. 1 and 2, the related art moisture-resistant photovoltaic module (hereinafter, simply referred to as a photovoltaic module) includes a plurality of solar cells (hereinafter, referred to as cells) 110, an encapsulant (low-density polyethylene (LDPE) 120 encapsulating (covering) upper and lower surfaces of the cells to protect the cells 110 from an external mechanical impact, a transparent insulating substrate 130 formed in a shape of a rectangular plate to cover an upper surface of the encapsulant 120, and a back sheet 140 adhered onto a lower surface of the encapsulant 120.

The encapsulant 120 is made of a polyethylene-based material. The back sheet 140 is formed in a manner of downwardly laminating a polyvinyl fluoride (PVF) layer, a polyethyleneterephthalate (PET) layer, and a PVF layer in a sequential manner.

However, when the encapsulant 120 covering the solar cells 110 is made of polyolefin, if the back sheet coming in contact with the polyolefin-based encapsulant 120 is formed in the typically used structure of PVF layer-PET layer-PVF layer, moisture resistance is lowered due to a reduced bonding force between the encapsulant 120 and the back sheet 140 or a surface roughness of the back sheet 140 is caused, which result in lowering of structural stability of a product.

### SUMMARY OF THE DISCLOSURE

Therefore, an aspect of the detailed description is to provide a photovoltaic module, capable of increasing moisture-resistance and enhancing structural stability of a product by increasing a bonding force between a polyolefin-based encapsulant and a back sheet, which comes in contact with the encapsulant, upon employing the polyolefin-based encapsulant.

To achieve these and other advantages and in accordance with the purpose of this specification, as embodied and broadly described herein, there is provided a photovoltaic module, including at least one solar cell, an encapsulant laminated to encapsulate upper and lower surfaces of the at least one solar cell, a transparent insulating substrate laminated on an upper surface of the encapsulant, and a back sheet laminated on a lower surface of the encapsulant, wherein the back sheet may be formed by sequentially laminating polyethylene (PE) layer, polyehthyleneterephthalate (PET) layer, and polyvinylidene fluoride (PVDF) layer, starting from the lower surface of the encapsulant.

The PE layer has a thickness in the range of 80 to 250 *µ*m, the PET layer in the range of 150 to 200 *µ*m, and the PVDF layer in the range of 10 to 50 *µ*m.

At least partial surface of the encapsulant may be coated with an ultraviolet (UV) absorbent.

The at least one solar cell may be provided in plurality, and the plurality of solar cells may be connected using a plurality of connection ribbons.

The encapsulant may be formed of a polyolefin-based material.

The encapsulant may be composed of homopolymers obtained by polymerizing chain hydrocarbons having one dual bond into monomers.

The encapsulant may be composed of copolymers with dissimilar olefin.

The encapsulant may contain low-density polyethylene (LDPE).

The encapsulant may further contain linear low-density polyethylene (LLDPE).

The encapsulant may be made of synthetic resin produced by polymerizing ethylene.

The encapsulant may be made of synthetic resin, which is present in a form of a transparent solid at room temperature and has a density value in the range of 0.91 g/cm² to 0.94 g/cm².

At least partial surface of the encapsulant may be coated with an ultraviolet (UV) absorbent.

To achieve these and other advantages and in accordance with the purpose of this specification, as embodied and broadly described herein, there is provided a method for fabricating a photovoltaic module, including laminating at least one cell, an encapsulant, a transparent insulating substrate and a back sheet on a heating plate of a laminator, melting the encapsulant to bond a front surface of the at least one cell onto a rear surface of the transparent insulating substrate and simultaneously a rear surface of the at least one cell onto a front surface of the back sheet and cooling the bonded laminate at room temperature.

Here, the melting of the encapsulant may be executed to heat the encapsulant by the laminator for 7 to 10 minutes under a temperature condition of 140 to 160°C.

In a photovoltaic module and a fabricating method thereof disclosed herein, an encapsulant which encapsulates cells may be formed of a polyolefin based material, and a back sheet may be formed by sequentially laminating polyethylene (PE) layer, polyehthyleneterephthalate (PET) layer, and polyvinylidene fluoride (PVDF) layer, starting from the lower surface of the encapsulant. It may be accordingly possible to prevent yellowing and corrosion caused due to moisture permeation and reduce a melting time required for bonding materials of the laminated module. This may result in enhancing productivity, improving a bonding force of the back sheet with respect to the polyolefin-based encapsulant, and preventing generation of a surface roughness. Consequently, structural stability of the photovoltaic module can be enhanced.

Further scope of applicability of the present application will become more apparent from the detailed description given hereinafter. However, it should be understood that the detailed description and specific examples, while indicating preferred embodiments of the disclosure, are given by way of illustration only, since various changes and modifications within the spirit and scope of the disclosure will become apparent to those skilled in the art from the detailed description.

### BRIEF DESCRIPTION OF THE DRAWINGS

The accompanying drawings, which are included to provide a further understanding of the disclosure and are incorporated in and constitute a part of this specification, illustrate exemplary embodiments and together with the description serve to explain the principles of the disclosure.

In the drawings:
FIG. 1 is a perspective view of a photovoltaic module according to the related art;
FIG. 2 is a sectional view of the photovoltaic module according to FIG. 1;
FIG. 3 is a sectional view of a photovoltaic module in accordance with the present disclosure;
FIG. 4 is a sectional view showing a part "A" of FIG. 3; and
FIG. 5 is a block diagram illustrating a lamination process in a method of fabricating a photovoltaic module in accordance with an exemplary embodiment disclosed herein.

### DETAILED DESCRIPTION OF THE DISCLOSURE

Description will now be given in detail of a photovoltaic module and a fabricating method thereof in accordance with one exemplary embodiment disclosed herein, with reference to the accompanying drawings.

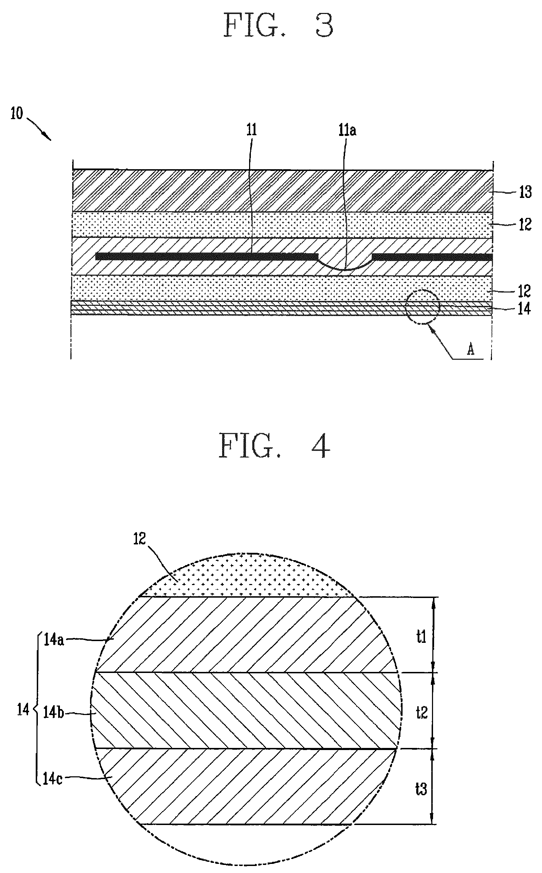

FIG. 3 is a sectional view of a photovoltaic module employing a low-density polyethylene (LDPE) protection film in accordance with an exemplary embodiment disclosed herein, FIG. 4 is a sectional view showing a part "A" of FIG. 3.

A photovoltaic module 10 according to an exemplary embodiment disclosed herein may include a plurality of cells 11, an encapsulant 12 encapsulating (or covering) upper and lower surfaces of each of the plurality of cells 11 to protect the plurality of cells 11 from an external impact, a transparent insulating substrate 13 formed in a shape of a rectangular plate to cover an upper surface of the encapsulant, and a back sheet 14 adhered onto a lower surface of the encapsulant 12. The photovoltaic module 10 may be formed in other shapes, except for the rectangular plate.

The plurality of cells 11 may absorb incident solar rays and convert the solar rays into electric energy or thermal energy. The plurality of cells 11 may be connected to one another using a plurality of connection ribbons 11 a. For example, the plurality of cells 11 may be connected in series or in parallel by the plurality of ribbons 11 a. Here, the cells 11 may absorb every beam (ray, light) with different wavelength bands, absorb only light with a specific wavelength band, or reflect only light with a specific wavelength band.

The encapsulant 12 may serve to more increase a bonding force between materials laminated on both surfaces of the cells 11 and protect the cells 11 from an external impact by encapsulating the cells 11 which are fragile. The polyolefin used as the encapsulant 12 disclosed herein refers to homopolymers, which are obtained by polymerizing chain hydrocarbons with one double bond into monomers, or copolymers with dissimilar olefin. This exemplary embodiment illustrates low-density polyethylene (LDPE)-based encapsulant as a representative example.

The LDPE has characteristics of very excellent moisture-resistance and electric insulation, and non-generation of acetic acid, unlike the related art EVA-based encapsulant, even if contacting moisture. LDPE-based resin, which is synthetic resin obtained by polymerizing ethylene, is present in a form of a transparent solid at room temperature. The LDPE-based resin also typically has density in the range of 0.91 g/cm² to 0.94 g/cm², exhibits high machinability and flexibility in view of low crystallization, is tolerable to an acid/alkali solution, and has superior transparency.

Types of such LDPE group may also include linear low-density polyethylene (LLDPE) with high durability, and the like, as well as the LDPE. The LLDPE has excellent heat-sealing intensity, even though having high heat-sealing temperature due to its higher melting point than the LDPE. However, in view of machinability, the LLDPE shows higher extrusion load and lower bubble stability than the LDPE. In this exemplary embodiment, if the LDPE is used as a film for protecting and bonding the cells 11, molding for providing a bonding force with respect to the cells 11 may be further facilitated and a melting time may further be shortened.

The encapsulant 12 according to this exemplary embodiment disclosed herein may allow for bonding between a front surface of each cell 11 and a rear surface of the transparent insulating substrate 13, and between a rear surface of each cell 11 and a front surface of the back sheet 14, in a manner of being heated or pressed for 7 to 10 minutes at temperature of about 150□. Comparing with the related art EVA-based encapsulant which was heated or pressed for about 15 to 30 minutes under the same temperature condition of about 150□, a fabricating method for the photovoltaic module 10 using the LDPE protection film can also considerably reduce a lamination time for a lamination process.

The encapsulant 12 according to this exemplary embodiment disclosed herein may have a thickness in the range of about 400 *µ*m and 600 *µ*m, preferably, in the range of about 450 *µ*m and 550 *µ*m.

The encapsulant 12 according to this exemplary embodiment disclosed herein may be laminated in a manner of coating a predetermined quantity of UV absorbent on at least partial surface of the LDPE protection film. In this case, light transmission as well as moisture-resistance of the encapsulant 12 can be more improved.

The encapsulant 12 according to this exemplary embodiment disclosed herein may also be laminated along with at least one different protection film to further increase the bonding force with the cells 11. In this case, the bonding force as well as the moisture-resistance of the encapsulant 12 can be more improved.

In the photovoltaic module 10 having the structure, it may be possible to prevent yellowing, which results from moisture permeation caused when the cells 11 are encapsulated using the EVA film, and electrode corrosion caused due to the yellowing. Therefore, the photovoltaic module can be stably utilized even in a humid ocean environment.

The transparent insulating substrate 13 may be implemented as a low-iron tempered glass with high light transmission and low light reflectivity. The transparent insulating substrate 13 may serve as a buffering member for protecting the cells 11 from an external impact, and be fabricated into various shapes depending on a design form of the photovoltaic module 10.

The back sheet 14 may be attached onto a lower surface of the encapsulant 12 so as to protect the solar cells 11 from an external environment. The back sheet 14 may preferably be formed of a material which can be easily, firmly bonded to the encapsulant 12 made of the LDPE-based material.

For example, the back sheet 14 may be produced in a manner of sequentially laminating polyethylene (PE) layer 14a, polyehthyleneterephthalate (PET) layer 14b and polyvinylidene fluoride (PVDF) layer 14c (i.e., in the order of 14a→14b→14c), in a direction getting away from the lower surface of the encapsulant 12.

The PE layer 14a may be about 80 to 250 *µ*m thick, the PET layer 14b may be about 150 to 200 *µ*m thick, and the PVDF layer 14c may be about 10 to 50 *µ*m thick.

Here, the PE layer 14a may be well bonded with the encapsulant 12 made of the LDPE group, the PET layer 14b may have excellent water-resistance, and the PVDF layer 14c may be advantageous in increasing intensity of the photovoltaic module.

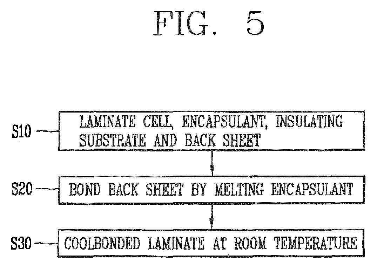

FIG. 5 is a block diagram illustrating a lamination process in a method of fabricating a photovoltaic module in accordance with an exemplary embodiment disclosed herein.

As illustrated in FIG. 5, the cells 11, the enclosure 12, the transparent insulating substrate 13 and the back sheet 14 may be laminated on a heating plate of a laminator (not illustrated) (S10).

The encapsulant 12 may then be melted using the laminator so as to bond a front surface of each cell 11 onto a rear surface of the transparent insulating substrate 13, and a rear surface of each cell 11 onto a front surface of the back sheet 14 (S20). Here, the encapsulant 12 may be melted in a manner of being heated by the laminator for 7 to 10 minutes under a temperature condition of 140 to 160°C. If the EVA film is used as the encapsulant 12 as illustrated in the related art, the melting time by the laminator generally extends to more than 15 to 30 minutes, and an additional processing is required to periodically discharge gas, which is generated from the EVA film due to the heating during the lamination process, to the outside. On the other hand, if the LDPE protection film is used as the encapsulant 12, the melting time of the protection film which is employed for bonding may be considerably reduced.

Afterwards, the bonded laminate may be cooled at room temperature to further enhance the bonding force, thereby completing the lamination process of the photovoltaic module (S30).

In the photovoltaic module 10 according to this exemplary embodiment disclosed herein, by employing the solar cells 11 and the LDPE-based protection film as the encapsulant 12 on both surfaces of each cell 11, electrode corrosion and reduction of light transmission, which result from yellowing caused due to moisture permeation, can be prevented. This may allow the photovoltaic module 10 to be applied even to a humid environment. In addition, a considerably reduced time may be taken to melt the LDPE protection film as the encapsulant 12, thereby enhancing productivity.

When the LDPE-based encapsulant is used, the back sheet having the structure of PVF layer-PET layer-PVF layer, which has been employed upon using the related art EVA-based encapsulant, may have a lowered bonding force with the LDPE-based encapsulant and visibly obtain a surface roughness. On the other hand, as illustrated in the exemplary embodiment disclosed herein, by forming the back sheet 14 into the structure of PE layer-PET layer-PVDF layer, the back sheet 14 can have an increased bonding force with the LDPE-based encapsulant and simultaneously be prevented from obtaining a visible surface roughness, which may result in enhancing structural stability of the thusly-fabricated photovoltaic module.

The configurations and methods of the mobile terminal in the aforesaid embodiments may not be limitedly applied, but such embodiments may be configured by a selective combination of all or part of the embodiments so as to implement many variations.

As the present features may be embodied in several forms without departing from the characteristics thereof, it should also be understood that the above-described embodiments are not limited by any of the details of the foregoing description, unless otherwise specified, but rather should be construed broadly within its scope as defined in the appended claims, and therefore all changes and modifications that fall within the metes and bounds of the claims, or equivalents of such metes and bounds are therefore intended to be embraced by the appended claims.

## Claims

1. A photovoltaic module, comprising:
at least one solar cell (11);
an encapsulant (12) laminated to encapsulate upper and lower surfaces of the at least one solar cell (11);
a transparent insulating substrate (13) laminated on an upper surface of the encapsulant (12); and
a back sheet (14) laminated on a lower surface of the encapsulant (12),
**characterized in that** the back sheet (14) is formed by sequentially laminating polyethylene (PE) layer, polyethyleneterephthalate (PET) layer, and polyvinylidene fluoride (PVDF) layer, starting from the lower surface of the encapsulant (12), wherein
the PE layer has a thickness in the range of 80 to 250µm, the PET layer in the range of 150 to 200µm, and the PVDF layer in the range of 10 to 50µm.

2. The photovoltaic module of claim 1, wherein at least partial surface of the encapsulant is coated with an ultraviolet (UV) absorbent.

3. The photovoltaic module of any one of claims 1 or 2, wherein the at least one solar cell is provided in plurality, and the plurality of solar cells are connected using a plurality of connection ribbons.

4. The photovoltaic module of any one of claims 1 or 3, wherein the encapsulant is formed of a polyolefin-based material.

5. The photovoltaic module of claim 4, wherein the encapsulant is composed of homopolymers obtained by polymerizing chain hydrocarbons having one dual bond into monomers.

6. The photovoltaic module of claim 4, wherein the encapsulant is composed of copolymers with dissimilar olefin.

7. The photovoltaic module of claim 4, wherein the encapsulant contains low-density polyethylene (LDPE).

8. The photovoltaic module of claim 7, wherein the encapsulant further contains linear low-density polyethylene (LLDPE).

9. The photovoltaic module of any one of claims 1 to 8, wherein the encapsulant is made of synthetic resin produced by polymerizing ethylene.

10. The photovoltaic module of any one of claims 1 to 9, wherein the encapsulant is made of synthetic resin, which is present in a form of a transparent solid at room temperature and has a density value in the range of 0.91 g/cm² to 0.94 g/cm².

11. A method for fabricating a photovoltaic module, according to any of the preceding claims comprising:
laminating at least one cell (11), an encapsulant (12), a transparent insulating substrate (13) and a back sheet (14) on a heating plate of a laminator;
melting the encapsulant to bond a front surface of the at least one cell (11) onto a rear surface of the transparent insulating substrate (13) and simultaneously a rear surface of the at least one cell (11) onto a front surface of the back sheet (14); and
cooling the bonded laminate at room temperature.

12. The method of claim 11, wherein the melting of the encapsulant (12) is executed to heat the encapsulant by the laminator for 7 to 10 minutes under a temperature condition of 140 to 160°C.

## Patentansprüche

1. Photovoltaikmodul umfassend:
zumindest eine Solarzelle (11);
eine Ummantelung (12), die laminiert ist, um obere und untere Oberflächen der zumindest einen Solarzelle (11) zu ummanteln;
ein transparentes Isoliersubstrat (13), das auf einer oberen Oberfläche der Ummantelung (12) laminiert ist; und
eine Rückplatte (14), die auf einer unteren Oberfläche der Ummantelung (12) laminiert ist,
**dadurch gekennzeichnet, dass** die Rückplatte (14) durch sequenzielles Laminieren von einer Polyethylen-(PE)-Schicht, einer Polyethylenterephthalat-(PET)-Schicht und einer Polyvinylidenfluorid-(PVDF)-Schicht gebildet ist, beginnend bei der unteren Oberfläche der Ummantelung (12), wobei die PE-Schicht eine Dicke in dem Bereich von 80 bis 250 µm, die PET-Schicht in dem Bereich von 150 bis 200 µm und die PVDF-Schicht in dem Bereich von 10 bis 50 µm aufweist.

2. Photovoltaikmodul nach Anspruch 1, wobei zumindest eine Teiloberfläche der Ummantelung mit einer ultravioletten (UV) Absorptionsschicht beschichtet ist.

3. Photovoltaikmodul nach irgendeinem der Ansprüche 1 oder 2, wobei die zumindest eine Solarzelle in einer Vielzahl bereitgestellt ist und die Vielzahl von Solarzellen unter Verwendung einer Vielzahl von Verbindungsbändern verbunden ist.

4. Photovoltaikmodul nach irgendeinem der Anspruch 1 oder 3, wobei die Ummantelung aus einem Polyolefin-basierten Material gebildet ist.

5. Photovoltaikmodul nach Anspruch 4, wobei die Ummantelung aus Homopolymeren zusammengesetzt ist, welche durch Polymerisierung von Kohlenwasserstoffketten, die eine Doppelbindung aufweisen, in Monomere, erhalten werden.

6. Photovoltaikmodul nach Anspruch 4, wobei die Ummantelung aus Copolymeren mit unterschiedlichem Olefin zusammengesetzt ist.

7. Photovoltaikmodul nach Anspruch 4, wobei die Ummantelung Polyethylen mit geringer Dichte (low-density polyethylene, LDPE) enthält.

8. Photovoltaikmodul nach Anspruch 7, wobei die Ummantelung ferner lineares Polyethylen mit geringer Dichte (linear low-density polyethylene, LLDPE) enthält.

9. Photovoltaikmodul nach irgendeinem der Ansprüche 1 bis 8, wobei die Ummantelung aus einem synthetischen Harz hergestellt ist, das durch Polymerisierung von Ethylen hergestellt wird.

10. Photovoltaikmodul nach irgendeinem der Ansprüche 1 bis 9, wobei die Ummantelung aus einem synthetischen Harz hergestellt ist, welches in einer Form eines transparenten Festkörpers bei Raumtemperatur vorliegt und einen Dichtewert im Bereich von 0,91 g/cm² bis 0,94 g/cm² aufweist.

11. Verfahren zum Herstellen eines Photovoltaikmoduls gemäß irgendeinem der vorhergehenden Ansprüche, umfassend:
Laminieren zumindest einer Zelle (11), einer Ummantelung (12), eines transparenten Isoliersubstrats (13) und einer Rückplatte (14) auf einer Heizplatte eines Laminators;
Schmelzen der Ummantelung, um eine Vorderoberfläche der zumindest einen Zelle (11) an eine Rückoberfläche des transparenten Isoliersubstrats (13) und
gleichzeitig eine Rückoberfläche der zumindest einen Zelle (11) an eine Vorderoberfläche der Rückplatte (14) zu binden; und
Kühlen des gebundenen Laminats bei Raumtemperatur.

12. Verfahren nach Anspruch 11, wobei das Schmelzen der Ummantelung (12) durch Erhitzen der Ummantelung durch den Laminator für 7 bis 10 Minuten unter einer Temperaturbedingung von 140 bis 160° C durchgeführt wird.

## Revendications

1. Module photovoltaïque, comprenant:
au moins une cellule solaire (11);
un encapsulant (12) stratifié pour encapsuler des surfaces supérieure et inférieure de l'au moins une cellule solaire (11);
un substrat isolant transparent (13) stratifié sur une surface supérieure de l'encapsulant (12); et
une feuille arrière (14) stratifiée sur une surface inférieure de l'encapsulant (12),
**caractérisé en ce que** la feuille arrière (14) est formée en stratifiant séquentiellement une couche de polyéthylène (PE), une couche de polyéthylène téréphtalate (PET) et
une couche de polyfluorure de vinylidène (PVDF), en partant de la surface inférieure de l'encapsulant (12), dans lequel la couche de PE a une épaisseur dans la plage de 80 à 250 µm, la couche de PET dans la plage de 150 à 200 µm et la couche de PVDF dans la plage de 10 à 50 µm.

2. Module photovoltaïque selon la revendication 1, dans lequel au moins une surface partielle de l'encapsulant est recouverte d'un absorbant ultraviolet (UV).

3. Module photovoltaïque selon l'une quelconque des revendications 1 ou 2, dans lequel l'au moins une cellule solaire est fournie en une pluralité, et la pluralité de cellules solaires sont connectées en utilisant une pluralité de rubans de connexion.

4. Module photovoltaïque selon l'une quelconque des revendications 1 ou 3, dans lequel l'encapsulant est formé d'un matériau à base de polyoléfine.

5. Module photovoltaïque selon la revendication 4, dans lequel l'encapsulant se compose d'homopolymères obtenus en polymérisant des hydrocarbures à chaîne ayant une liaison double en des monomères.

6. Module photovoltaïque selon la revendication 4, dans lequel l'encapsulant se compose de copolymères avec une oléfine dissemblable.

7. Module photovoltaïque selon la revendication 4, dans lequel l'encapsulant contient du polyéthylène basse densité (LDPE).

8. Module photovoltaïque selon la revendication 7, dans lequel l'encapsulant contient en outre du polyéthylène basse densité linéaire (LLDPE).

9. Module photovoltaïque selon l'une quelconque des revendications 1 à 8, dans lequel l'encapsulant est constitué de résine synthétique produite en polymérisant de l'éthylène.

10. Module photovoltaïque selon l'une quelconque des revendications 1 à 9, dans lequel l'encapsulant est constitué de résine synthétique, qui est présente sous une forme d'un solide transparent à température ambiante et a une valeur de densité dans la plage de 0,91 g/cm² à 0,94 g/cm².

11. Procédé pour fabriquer un module photovoltaïque, selon l'une quelconque des revendications précédentes comprenant:
la stratification d'au moins une cellule (11), d'un encapsulant (12), d'un substrat isolant transparent (13) et d'une feuille arrière (14) sur une plaque chauffante d'un dispositif de stratification;
la fusion de l'encapsulant pour lier une surface avant de l'au moins une cellule (11) sur une surface arrière du substrat isolant transparent (13) et simultanément une surface arrière de l'au moins une cellule (11) sur une surface avant de la feuille arrière (14); et
le refroidissement du stratifié lié à température ambiante.

12. Procédé selon la revendication 11, dans lequel la fusion de l'encapsulant (12) est exécutée pour chauffer l'encapsulant par le dispositif de stratification pendant 7 à 10 minutes à une condition de température de 140 à 160 °C.
